# EUROPEAN PATENT SPECIFICATION

(11) **EP 4 089 543 B1**
(45) Date of publication and mention of the grant of the patent: **08.04.2026**
(21) Application number: 20918817.6
(22) Date of filing: 13.02.2020
(51) Int. Cl.: G11C 5/04, G06F 13/16, G11C 7/10

(54) **MEMORY, NETWORK DEVICE, AND DATA ACCESS METHOD**
SPEICHER, NETZWERKVORRICHTUNG UND DATENZUGRIFFSVERFAHREN
MÉMOIRE, DISPOSITIF DE RÉSEAU, ET PROCÉDÉ D'ACCÈS À DES DONNÉES

(43) Date of publication of application: 16.11.2022
(73) Proprietor: Huawei Technologies Co., Ltd., Shenzhen, Guangdong 518129 (CN)
(72) Inventor: ZHANG, Xianfu, Shenzhen, Guangdong 518129 (CN); WANG, Zhengbo, Shenzhen, Guangdong 518129 (CN)
(74) Representative: Grünecker Patent- und Rechtsanwälte PartG mbB
(86) International application number: PCT/CN2020/075139
(87) International publication number: WO 2021/159412

(56) References cited:
- CN-A- 108 628 776
- CN-A- 108 701 108
- CN-A- 109 840 223
- CN-A- 110 633 229
- CN-A- 110 633 229
- US-A- 6 049 487
- US-A1- 2003 081 479
- US-A1- 2012 300 570
- US-A1- 2014 215 164
- US-A1- 2017 371 594
- US-A1- 2019 163 650

## Description

### TECHNICAL FIELD

This application relates to the field of memory technologies, and in particular, to a memory, a network device, and a data access method.

### BACKGROUND

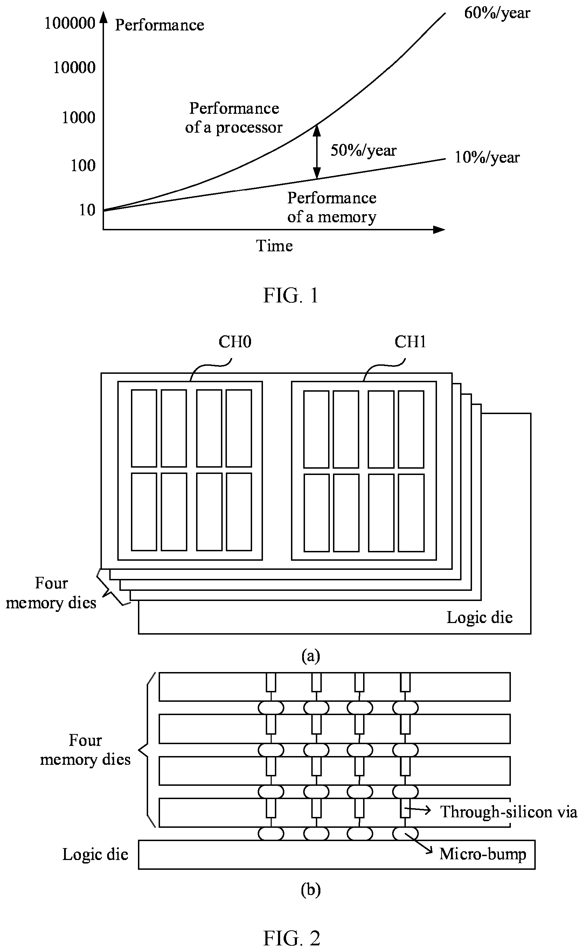

A memory and a processor are separately used as two important components of an electronic device for storing information and processing information, and performance of the memory and the processor directly affects performance of a network device. In recent decades, as shown in FIG. 1, performance of a processor is improved significantly at a speed of about 60% each year, and performance of a memory is improved at a speed of only about 10% each year. Over years, the unbalanced development speed causes a load/store speed of the current memory to severely lag behind a computing speed of the processor. The storage bottleneck makes a high-performance processor unable to play its due role. This greatly restricts increasing high-performance computing.

A memory bandwidth is a parameter used for measuring a load/store speed of a memory, and is an amount of data transmitted through a data bus in a unit time. The memory bandwidth may be calculated according to a formula: Memory bandwidth = (Transmission rate x Bus bit width x Operating frequency)/8. The unit is byte/second (byte/s). The bus bit width refers to a quantity of bits of a storage data bus, the operating frequency refers to a memory clock frequency, and the transmission rate refers to a quantity of times that each data bus transmits data in a clock pulse period. It is clear that a size of the memory bandwidth depends on three factors: the bus bit width, the operating frequency, and the transmission rate.

In a conventional technology, a memory bandwidth is usually increased by increasing a storage transmission rate. For example, DDR storage is at a double data rate. Each data line of the DDR storage can prefetch 2-bit data from a storage unit, and separately transmit 1-bit data at a rising edge and a falling edge of a clock pulse. In other words, a transmission rate in one clock cycle is 2. At a same frequency, an amount of transmitted data in the DDR storage is twice that in single data rate storage. Similarly, transmission rates of DDR2 storage and DDR3 storage are four times and eight times of the single data rate storage respectively. US 6 049 487 A discloses A dual ported (simultaneous read/write) SRAM block with an additional load port that interacts with the circuitry employed in the loading and testing of the configuration data of the FPGA core. US 2014/215164 A1 describes techniques and apparatuses for multiport memory architecture.

However, it is difficult for network devices such as a switch and a router to exert their advantages in the foregoing manner of increasing the memory bandwidth. This is because these network devices require different memory bandwidths for forwarding different data such as a service packet and a service entry. Generally, a read/write bandwidth required by the service packet is 50% read and 50% write, and a read/write bandwidth required by the service entry is 95% read and 5% write. Therefore, how to meet requirements of a same device for different memory bandwidths is an urgent technical problem to be resolved.

Documents US6049487, US2014215164 and US2017371594 disclose the preamble of claims 1 and 8.

### SUMMARY

This application provides a memory, a network device, and a data access method, to meet requirements of a same device for different memory bandwidths. The invention is defined according to the independent claims. The dependent claims recite advantageous embodiments of the invention.

To achieve the foregoing objectives, the following technical solutions are used in embodiments of this application.

According to a first aspect, a memory is provided. The memory includes at least one channel. The at least one channel includes a first channel. The first channel corresponds to a first read bus group and a first read/write bus group. The first read bus group is configured to read data of the first channel. The first read/write bus group is configured to read data of the first channel and write data into the first channel.

In the foregoing technical solution, the first channel in the memory corresponds to the first read bus group and the first read/write bus group. When the first channel in the memory is accessed, the first read/write bus group may be adaptively used as a read bus group or a write bus group based on a read/write bandwidth requirement during data read/write, so that the first read bus group and the first read/write bus group access the first channel in the memory. For example, if read/write bandwidth requirements are balanced (for example, a read/write bandwidth is 50% read and 50% write), the first read/write bus group serving as a write bus group reads/writes the memory together with a first read bus. When a read bandwidth requirement is greater than a write bandwidth requirement (for example, a read/write bandwidth is 95% read and 5% write), the first read/write bus group serving as a read bus group reads data from the memory together with the first read bus. In this way, requirements of a same memory for different read/write bandwidths can be implemented.

According to the first aspect, the at least one channel further includes a second channel. The second channel corresponds to a second read/write bus group. The second read/write bus group is configured to read data of the second channel and write data into the second channel. The second channel corresponds to the second read/write bus group, so that the second channel in the memory may be accessed through a second read/write bus group.

In a possible implementation of the first aspect, bus bit widths of the first read/write bus group and the second read/write bus group are different. In the foregoing possible implementation, bit widths of data buses included in the first read/write bus group and the second read/write bus group are different, and/or bit widths of address buses included in the first read/write bus group and the second read/write bus group are different. The different bit widths of data buses may include different bit widths of read data lines and/or different bit widths of write data lines.

According to the first aspect, the first read/write bus group has a different read/write function from that in the second read/write bus group, i.e. the first read/write bus group supports bit mask write, and the second read/write bus group supports byte mask write. This improves access flexibility of the memory.

In a possible implementation of the first aspect, the second channel further corresponds to a second read bus group. The second read bus group is configured to read data of the second channel. In the foregoing possible implementation, the second channel in the memory corresponds to the second read bus group and the second read/write bus group. When the second channel in the memory is accessed, the second read/write bus group may be adaptively used as a read bus group or a write bus group based on a read/write bandwidth requirement during data read/write. Further, the second read bus group and the second read/write bus group are used for accessing the second channel in the memory, to meet requirements of a same memory for different read/write bandwidths.

In a possible implementation of the first aspect, bus bit widths of the first read bus group and the second read bus group are different. In the foregoing possible implementation, bit widths of data buses included in the first read bus group and the second read bus group are different, and/or bit widths of address buses included in the first read bus group and the second read bus group are different.

In a possible implementation of the first aspect, at least one read bus in the first read bus group has a different read function from that in the second read bus group. In the foregoing possible implementation, a read function of the first read bus group may be different from that of the second read bus group. For example, the first read bus group supports bit mask read, and the second read bus group supports byte mask read. This improves access flexibility of the memory.

In a possible implementation of the first aspect, the read bus group and the read/write bus group each include a control bus, an address bus, and a data bus.

In a possible implementation of the first aspect, the memory includes N static random access memories SRAMs in a three-dimensional stacking manner. N is an integer greater than 1. In the foregoing possible implementation, the memory including the N SRAMs in the three-dimensional stacking manner can meet requirements of a same storage device for different memory bandwidths.

In a possible implementation of the first aspect, each of the at least one channel includes a plurality of memory banks. The plurality of memory banks included in each channel are correspondingly provided with a read bus group and a read/write bus group. In the foregoing possible implementation, each channel in the memory can meet requirements of a same channel for different read/write bandwidths.

According to a second aspect, a network device is provided. The network device includes a processor and a memory. The processor is configured to access the memory. The memory is the memory provided in any one of the first aspect and the possible implementations of the first aspect.

In a possible implementation of the second aspect, the network device is a network switching and forwarding device.

In a possible implementation of the second aspect, the network switching and forwarding device includes a router or a switch.

According to a third aspect, a data access method is provided, applied to a network device including a processor and a memory. The memory includes a first channel. The first channel corresponds to a first read bus group and a first read/write bus group. The method includes: The processor accesses the first channel in the memory through the first read bus group and the first read/write bus group.

In a possible implementation of the third aspect, that the processor accesses the first channel in the memory through the first read bus group and the first read/write bus group includes: The processor enables the first read/write bus group as a write bus group; and the processor reads data of the first channel in the memory through the first read bus group, and writes data into the first channel in the memory through the first read/write bus group.

In a possible implementation of the third aspect, that the processor accesses the first channel in the memory through the first read bus group and the first read/write bus group further includes: The processor enables the first read/write bus group as a read bus group; and the processor reads data of the first channel in the memory through the first read bus group and the first read/write bus group.

In a possible implementation of the third aspect, since the memory further includes a second channel which corresponds to a second read/write bus group, the method further includes: The processor accesses the second channel in the memory through the second read/write bus group.

In a possible implementation of the third aspect, the second channel further corresponds to a second read bus group. The method further includes: The processor reads data of the second channel through the second read bus group.

It may be understood that any one of the network device and the data access method provided above includes the memory provided above. Therefore, for beneficial effects that can be achieved by the network device and the data access method, refer to the beneficial effects in the memory provided above. Details are not described herein again.

### BRIEF DESCRIPTION OF DRAWINGS

FIG. 1 is a schematic diagram of comparison between an increase of performance of a processor and an increase of performance of a memory;
FIG. 2 is a schematic diagram of a structure of an HBM according to an embodiment of this application;
FIG. 3 is a schematic diagram of a memory according to an embodiment of this application;
FIG. 4 is a schematic diagram of a network device according to an embodiment of this application; and
FIG. 5 is a schematic flowchart of a data access method according to an embodiment of this application.

### DESCRIPTION OF EMBODIMENTS

In this application, "at least one" means one or more, and "a plurality of" means two or more. And/or describes an association relationship between associated objects, and represents that three relationships may exist. For example, A and/or B may represent the following cases: Only A exists, both A and B exist, and only B exists, where A and B may be singular or plural. The character "/" generally indicates an "or" relationship between the associated objects. At least one of the following items (pieces) or a similar expression thereof indicates any combination of these items, including a single item (piece) or any combination of a plurality of items (pieces). For example, at least one item (piece) of a, b, or c may indicate: a, b, c, a and b, a and c, b and c, or a, b, and c, where a, b, and c may be singular or plural. In addition, in embodiments of this application, terms such as "first" and "second" are used for distinguishing between same objects or similar objects whose functions and purposes are basically the same. For example, a first threshold and a second threshold are merely used for distinguishing between different thresholds, and a sequence thereof is not limited. A person skilled in the art may understand that the terms such as "first" and "second" do not limit a quantity or an execution sequence.

It should be noted that, in this application, words such as "example" or "for example" are used for representing giving an example, an illustration, or a description. Any embodiment or design scheme described as an "example" or "for example" in this application should not be explained as being more preferred or having more advantages than another embodiment or design scheme. Exactly, use of the word "example", "for example", or the like is intended to present a relative concept in a specific manner.

Before embodiments of this application are described, the technical background in embodiments of this application is described first.

A memory and a processor are separately used as two important components of an electronic device for storing information and processing information, and performance of the memory and the processor directly affects performance of a network device. In recent decades, as shown in FIG. 1, performance of a processor is improved significantly at a speed of about 60% each year, and performance of a memory is improved at a speed of only about 10% each year. A gap between speed improvement on the performance of the processor and the memory is about 50% per year. Over years, the unbalanced development speed causes a load/store speed of the current memory to severely lag behind a computing speed of the processor. The storage bottleneck makes a high-performance processor unable to play its due role. This greatly restricts increasing high-performance computing. Actually, as early as 1994, scientists analyzed and predicted this problem, and named the storage bottleneck that severely hinders performance of a processor as the memory wall.

A memory bandwidth is a parameter used for measuring a load/store speed of a memory, and is an amount of data transmitted through a data bus in a unit time. The memory bandwidth may be calculated according to a formula: Memory bandwidth = (Transmission rate x Bus bit width x Operating frequency)/8. The unit is byte/second (byte/s). The bus bit width refers to a quantity of bits of a storage data bus, the operating frequency refers to a memory clock frequency, and the transmission rate refers to a quantity of times that each data bus transmits data in a clock pulse period. It is clear that a size of the memory bandwidth depends on three factors: the bus bit width, the operating frequency, and the transmission rate.

Increasing the memory bus bit width: In an existing architecture in which an independent memory chip is used, further increasing the storage bit width is limited by a quantity of data line pins of the memory chip. Therefore, a new memory architecture that can effectively eliminate the pin limitation needs to be used for increasing the bit width to increase the memory bandwidth. For example, a memory-processor integration technology has a feature of significantly improving a memory bandwidth by increasing a storage bit width.

Increasing the storage operating frequency: A method for increasing the memory bandwidth merely by increasing the operating frequency is restricted by aspects such as increases in an amount of heat generation and a process difficulty of the memory chip. Therefore, space for further improving the memory bandwidth by using this method is very limited.

Improving the storage transmission rate: To improve the memory bandwidth by increasing the transmission rate. For example, DDR storage is at a double data rate. Each data line of the DDR storage can prefetch 2-bit data from a storage unit, and separately transmit 1-bit data at a rising edge and a falling edge of a clock pulse. In other words, a transmission rate in one clock cycle is 2. At a same frequency, an amount of transmitted data in the DDR storage is twice that in single data rate storage. Similarly, transmission rates of DDR2 storage and DDR3 storage are four times and eight times of the single data rate storage respectively. The "terabyte bandwidth" technology of Rambus can increase the transmission rate to 32. This greatly improves the memory bandwidth.

However, it is difficult for network devices such as a switch and a router to exert their advantages in the foregoing manner of increasing the memory bandwidth. This is because these network devices require different memory bandwidths for forwarding different data such as a service packet and a service entry. Generally, a read/write bandwidth required by the service packet is 50% read and 50% write, and a read/write bandwidth required by the service entry is 95% read and 5% write. In view of this, embodiments of this application provide a memory, a network device, and a data access method, to meet requirements of a same storage device for different memory bandwidths, and increase the memory bandwidth.

The technical solutions of this application may be applied to various memories, for example, a flash and a random access memory (RAM). In a possible embodiment, the technical solutions of this application may be applied to various types of RAMs, such as a static random access memory (SRAM), a dynamic random access memory (DRAM), and a synchronous dynamic random access memory (SDRAM). The DRAM may further include a multi-rate DRAM, a high bandwidth memory (HBM), and the like. A multiple data rate DRAM may include a double data rate synchronous dynamic random access memory (double data rate SDRAM, DDR SDRAM), a DDR2 SDRAM, a DDR3 SDRAM, a DDR4 SDRAM, a DDR5 SDRAM, and the like.

The following describes features of different memories by using an SRAM, a DDR SDRAM, and an HBM as examples.

The SRAM is a type of the random access memory RAM. The so-called "static" means that as long as the memory is kept powered on, data stored in the memory can be retained constantly. In contrast, data stored in the dynamic random access memory (DRAM) needs to be updated periodically. However, when the power supply is stopped, the data stored in the SRAM still disappears (called volatile memory), which is different from a ROM or flash memory that can still store data after a power off.

The DDR SDRAM may be referred to as DDR for short, and a data transmission speed of the DDR SDRAM is twice or more times that of a system clock. Due to an increase in the speed, transmission performance of the DDR SDRAM is better than that of a conventional SDRAM. The DDR SDRAM can transmit data at both a rising edge and a falling edge of the system clock.

Table 1 lists a bus clock, an internal rate, a prefetch, a transfer rate, and a voltage of SDRAMs with different data rates such as DDR, DDR2, DDR3, and DDR4. Table 2 lists a quantity of pins when the SDRAMs with different data rates are implemented by using different types of memory modules. Different types of memory modules may include a dual inline memory module (DIMM), a small outline dual inline memory module (SO-DIMM), and a micro dual inline memory module (micro DIMM).

**Table 1**

| SDRAM | Bus clock (MHz) | Internal rate (MHz) | Prefetch (min burst) | Transfer rate (MT/s) | Voltage (V) |
|---|---|---|---|---|---|
| DDR | 100-200 | 100-200 | 2n | 200-400 | 2.5/2.6 |
| DDR2 | 200-533 | 100-266 | 4n | 400-1066 | 1.8 |
| DDR3 | 400-1066 | 100-266 | 8n | 800-2400 | 1.5 |
| DDR4 | 800-1200 | 200-300 | 16n | 1600-5067 | 1.2 |

**Table 2**

| SDRAM | DIMM (pins) | SO-DIMM (pins) | micro DIMM (pins) |
|---|---|---|---|
| DDR | 184 | 200 | 172 |
| DDR2 | 240 | 200 | 214 |
| DDR3 | 240 | 204 | 214 |
| DDR4 | 288 | 260 | 214 |

The HBM is a high-performance DRAM based on a 3D stack technology and is initiated by Samsung Electronics, Supermicro, and SK hynix, that is, a memory that has a high bandwidth feature and that is formed by stacking and packaging a plurality of DRAM dies such as 2/4/8 based on the 3D stack technology. The HBM applies to applications with high memory bandwidth requirements, such as a graphics processing unit and a network switching and forwarding device (such as a router and a switch). Compared with the DDR4 or the DDR5, the HBM achieves a higher bandwidth with a smaller size and less power.

FIG. 2 is a schematic diagram of a structure of an HBM die according to an embodiment of this application. The HBM die may include a logic die and a plurality of memory dies. The plurality of memory dies are stacked together through through-silicon vias (TSV) and micro-bumps, and are connected to the logic die. The logic die may be a die integrating control logic. The control logic may be a memory controller, and may be specifically configured to manage and control read/write of the plurality of memory dies, and the like.

Storage units in the memory die are divided into a plurality of memory banks. The plurality of memory banks are divided into a plurality of channels based on data buses, address buses, and control buses corresponding to the plurality of memory banks. In other words, memory banks in a same channel read/write data through one or more same buses. The buses herein include a data bus, an address bus, and a control bus. Memory banks in different channels read/write data through different buses.

In this embodiment of this application, each memory die may include two channels. Each channel may be 128 bits. One channel may also be referred to as a channel. One channel may include a plurality of memory banks. An example in which the HBM die includes four memory dies, each memory die includes two channels CH0 and CH1, and each channel includes eight memory banks is used for description in FIG. 2. (a) in FIG. 2 is a top view of the HBM die, and (b) in FIG. 2 is a side view of the HBM die.

It should be noted that the plurality of memory dies in FIG. 2 may be a plurality of DRAM dies, or may be a plurality of SRAM dies. To be specific, the plurality of DRAMs may form a memory in the three-dimensional stacking manner shown in FIG. 2, or the plurality of SRAMs may form a memory in the three-dimensional stacking manner shown in FIG. 2. A specific type of the memory die is not limited in this embodiment of this application.

In addition, a difference between the memory formed by the plurality of SRAMs in the three-dimensional stacking manner and the memory formed by the DRAMs in the three-dimensional stacking manner lies in that, in the memory formed by the DRAMs in the three-dimensional stacking manner, one channel corresponds to one group of data buses. A reason is that, limited by a DRAM timing parameter, a bandwidth of one channel is close to a sum of all memory banks in the channel. However, for the memory formed by the plurality of SRAMs in the three-dimensional stacking manner, because the SRAM does not have a timing parameter limitation similar to that of the DRAM, and a bandwidth of a single memory bank matches a bandwidth of a single channel, the memory formed by the plurality of SRAMs in the three-dimensional stacking manner may support access by a plurality of groups of buses, so that the bandwidth can be increased by expanding the plurality of groups of buses. In view of this, an embodiment of this application provides a memory that supports access by a plurality of groups of buses.

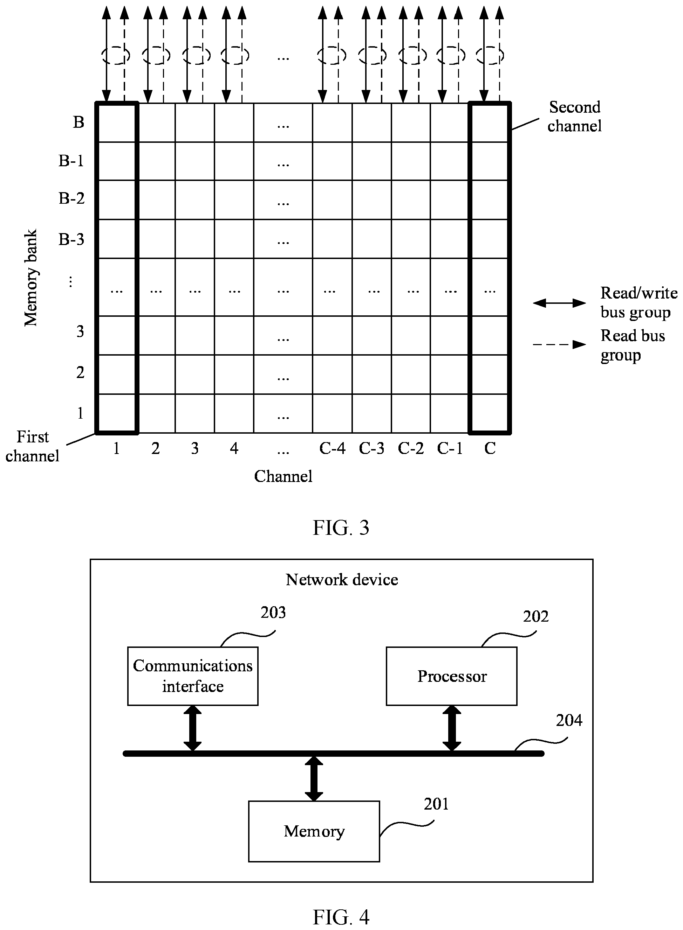

FIG. 3 is a schematic diagram of a structure of a memory according to an embodiment of this application. The memory includes at least one channel. The at least one channel includes a first channel. The first channel corresponds to a first read bus group and a first read/write bus group. The first read bus group is configured to read data of the first channel. The first read/write bus group is configured to read data of the first channel and write data into the first channel. Optionally, the memory may be a memory formed by a plurality of SRAMs in a three-dimensional stacking manner.

The at least one channel includes more channels. The first channel may be any channel in the at least one channel. Each channel may include a plurality of continuous memory banks. The plurality of continuous memory banks may be correspondingly provided with a read bus group and a read/write bus group. For example, in FIG. 3, an example in which the at least one channel includes C channels, each channel includes B continuous memory banks, and the first channel is the first of the C channels is used for description. C is a positive integer.

In addition, the first read bus group may include a control bus, an address bus, and a data bus. For example, in the first read bus group, the control bus may include a clock line CLK and a chip enable line CEN, the address bus may include m1 address lines A[m1-1:0], and the data bus may include n1 read data lines Q[n1-1:0]. m1 and n1 are positive integers. For example, m1 is equal to 32, and n1 is equal to 128.

A description of each type of bus in the first read bus group may be shown in the following Table 3. Specifically, an input/output type of the clock line CLK is an input, a power supply is VDDP/VDD, and the clock line CLK is defined as a system clock input. An input/output type of the chip enable line CEN is an input, a power supply is VDDP/VDD, and the chip enable line CEN is defined as a chip enable input and is active low. An input/output type of the address bus A[m1-1:0] is an input, a power supply is VDDP/VDD, and the address bus A[m1-1:0] is defined as an address input bus port. An input/output type of the data bus Q[n1-1:0] is an output, a power supply is VDDP/VDD, and the data bus Q[n1-1:0] is defined as a read output data bus for a read port.

**Table 3 First read bus group**

| | | | |
|---|---|---|---|
| CLK | Input | VDDP/VDD | System clock input |
| CEN | Input | VDDP/VDD | Chip enable input, active low |
| A[m1-1:0] | Input | VDDP/VDD | Address input bus port |
| Q[n1-1:0] | Output | VDDP/VDD | Read output data bus for read port |

The first read/write bus group may also include a control bus, an address bus, and a data bus. For example, in the first read/write bus group, the control bus may include a clock line CLK, a chip enable line CEN, and a write enable line WEN, the address bus may include m2 address lines A[m2-1:0], and the data bus may include n2 read data lines Q[n2-1:0] and n3 write data lines D[n3-1:0]. m1 and n1 are positive integers. For example, m2 is equal to 64, n2 is equal to 128, and n3 is equal to 128.

A description of each type of bus in the first read/write bus group may be shown in the following Table 4. Specifically, an input/output type of the clock line CLK is an input, a power supply is VDDP/VDD, and the clock line CLK is defined as a system clock input. An input/output type of the chip enable line CEN is an input, a power supply is VDDP/VDD, and the chip enable line CEN is defined as a chip enable input and is active low. An input/output type of the address bus A[m2-1:0] is an input, a power supply is VDDP/VDD, and the address bus A[m2-1:0] is defined as an address input bus port. An input/output type of the read data bus Q[n2-1:0] is an output, a power supply is VDDP/VDD, and the read data bus Q[n2-1:0] is defined as a read output data bus for a read port. An input/output type of the write enable line WEN is an input, a power supply is VDDP/VDD, and the write enable line WEN is defined as a write enable input and is active low. An input/output type of the write data bus D[n3-1:0] is an input, a power supply is VDDP/VDD, and the write data bus D[n3-1:0] is defined as a write input data bus for a write port.

**Table 4 First read/write bus group**

| | | | |
|---|---|---|---|
| CLK | Input | VDDP/VDD | System clock input |
| CEN | Input | VDDP/VDD | Chip enable input, active low |
| A[m2-1:0] | Input | VDDP/VDD | Address input bus port |
| Q[n2-1:0] | Output | VDDP/VDD | Read output data bus for read port |
| WEN | Input | VDDP/VDD | Write enable input, active low |
| D[n3-1:0] | input | VDDP/VDD | Write input data bus for write port |

Specifically, when the write enable line WEN is at a high level, the first read/write bus group may be used as a read bus group. That is, data of the first channel in the memory may be read through the clock line CLK, the chip enable line CEN, the address bus A[m2-1:0], and the read data bus Q[n2-1:0]. When the write enable line WEN is at a low level, the first read/write bus group may be used as a write bus group. That is, data may be written into the first channel in the memory through the clock line CLK, the chip enable line CEN, the address bus A[m2-1:0], and the write data bus D[n3-1:0]. For example, when the first channel in the memory is accessed, if a read bandwidth is basically the same as a write bandwidth, the first read/write bus group may be used as a write bus group, data of the first channel is read based on the first read bus group, and data is written into the first channel based on the first read/write bus group; or if the read bandwidth is greater than the write bandwidth, the first read/write bus group may be used as a read bus group, and data of the first channel is read based on the first read bus group and the first read/write bus group.

In this embodiment of this application, the first channel in the memory corresponds to the first read bus group and the first read/write bus group. When the first channel in the memory is accessed, the first read/write bus group may be adaptively used as a read bus group or a write bus group based on a read/write bandwidth requirement during data read/write, so as to access the first channel in the memory based on the first read bus group and the first read/write bus group. This meets requirements of a same memory for different read/write bandwidths.

As shown in FIG. 3, the at least one channel further includes a second channel. The second channel corresponds to a second read/write bus group. The second read/write bus group is configured to read data of the second channel or write data into the second channel. In FIG. 3, an example in which the second channel is a Cth channel is used for description. Descriptions of various types of buses included in the first read/write bus group are basically the same as those of the second read/write bus group. For details, refer to the descriptions of the first read/write bus group. Details are not described herein again in this embodiment of this application.

In an example not covered by the claims, the first read/write bus group and the second read/write bus group may use a homogeneous bus architecture.According to the invention, the first read/write bus group and the second read/write bus group use a heterogeneous bus architecture. The homogeneous bus architecture means that all buses in the first read/write bus group and the second read/write bus group are completely the same. For example, bit widths of buses of various types are the same, and read/write functions of buses of a same type are the same. The heterogeneous bus architecture means that there are different buses in the first read bus group and the second read/write bus group. According to the invention, there are buses of the same type which have different read/write functions. They may additionally have different bit widths. In an example not covered by the claims, there are buses of different types.

In a possible embodiment, that bus bit widths of the first read/write bus group and the second read/write bus group are different may specifically mean that bit widths of data buses included in the first read/write bus group and the second read/write bus group are different, and/or bit widths of address buses included in the first read/write bus group and the second read/write bus group are different. The different bit widths of data buses may include different bit widths of read data lines and/or different bit widths of write data lines. For example, if the first read/write bus group includes m2 address lines, n2 read data lines, and n3 write data lines, the second read/write bus group includes m3 address lines, n4 read data lines, and n5 write data lines, that bus bit widths of the first read/write bus group and the second read/write bus group are different may specifically include: m2 is unequal to m3, n2 is unequal to n4, and/or n3 is unequal to n5.

According to the invention, that at least one read/write bus in the first read/write bus group has a different read/write function from that in the second read/write bus group specifically means that read functions of read data lines included in the first read/write bus group and the second read/write bus group are different, and/or write functions of write data lines included in the first read/write bus group and the second read/write bus group are different. For example, if the first read/write bus group includes n2 read data lines and n3 write data lines, and the second read/write bus group includes n4 read data lines and n5 write data lines, that read/write functions of the first read/write bus group and the second read/write bus group are differen specifically means: The n2 read data lines support bit mask read, the n3 write data lines support bit mask write, the n4 read data lines support byte mask read, and the n5 write data lines support byte mask write.

For example, the write data bus D[n3-1:0] in the first read/write bus group supports bit mask write, a definition corresponding to the write data bus D[n3-1:0] may be a bit write mask bus for the write port, and is active high, as shown in Table 5 below.

**Table 5**

| | | | |
|---|---|---|---|
| D[n3-1:0] | Input | VDDP/VDD | Bit write mask bus for write port, active high |

In an actual application, the second channel may correspond to one group of buses, or may correspond to two groups of buses. For example, when the second channel corresponds to one group of buses, the second channel corresponds to only the second read/write bus group. That is, the second channel can be accessed only through the second read/write bus group. When the second channel corresponds to two groups of buses, in addition to corresponding to the second read/write bus group, the second channel may also correspond to a second read bus, that is, similar to the first channel, the second channel may correspond to a group of read buses and a group of read/write buses.

As shown in FIG. 3, the second channel further corresponds to a second read bus group. The second read bus group is configured to read data of the second channel. Descriptions of various types of buses included in the first read bus group are basically the same as those of the second read bus group. For details, refer to the descriptions of the first read bus group. Details are not described herein again in this embodiment of this application.

In a possible embodiment, that bus bit widths of the first read bus group and the second read bus group are different may specifically mean that bit widths of read data lines included in the first read bus group and the second read bus group are different, and/or bit widths of address buses included in the first read bus group and the second read bus group are different. In another possible embodiment, at least one read bus in the first read bus group has a different read function from that in the second read bus group.

It should be noted that for related descriptions of different bus bit widths of the first read bus group and the second read bus group and different read functions of the read buses, refer to the related descriptions of the first read/write bus group and the second read/write bus group. Details are not described herein again in this embodiment of this application.

In an actual application, the first channel or the second channel may further correspond to a bus with another function. The another function may include data bus inversion (DBI), data input mask (DM), clock enable (CKE), parity (PAR), data error (DERR), strobe, address error (AERR), and the like. This is not described in detail in this embodiment of this application.

In a possible embodiment, the memory may alternatively be another memory, for example, a memory formed by stacking a plurality of flash dies or a memory formed by a plurality of MRAM dies. This is not specifically limited in this embodiment of this application.

FIG. 4 is a schematic diagram of a structure of a network device according to an embodiment of this application. The network device includes a memory 201 and a processor 202 coupled to the memory 201. The memory 201 is the memory provided in FIG. 3, and may be configured to store instructions, data, and the like. The processor 202 is configured to control and manage an action of the network device, and the like. The network device further includes a communications interface 203 and a bus 204. The memory 201, the processor 202, and the communications interface 203 are connected through the bus 204. The communications interface 203 is configured to support communication between the network device and another device.

The processor 202 may be a central processing unit, a general-purpose processor, a digital signal processor, an application-specific integrated circuit, a field programmable gate array or another programmable logic device, a transistor logic device, a hardware component, or any combination thereof. The processor may implement or execute various example logical blocks, modules, and circuits described with reference to content disclosed in this application. Alternatively, the processor may be a combination of processors implementing a computing function, for example, a combination of one or more microprocessors, or a combination of a digital signal processor and a microprocessor. The bus 204 may be a peripheral component interconnect (PCI) standard bus, an extended industry standard architecture (EISA) bus, or the like. The bus 204 may be classified into an address bus, a data bus, a control bus, and the like. For ease of representation, only one thick line is used to represent the bus in FIG. 4, but this does not mean that there is only one bus or only one type of bus.

In a possible embodiment, the network device is a network switching and forwarding device. Optionally, the network switching and forwarding device may include a router, a switch, or the like.

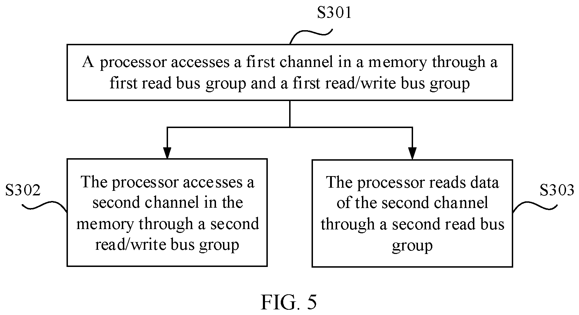

FIG. 5 is a schematic flowchart of a data access method according to an embodiment of this application. The method may be applied to a network device including a processor and a memory. The memory includes a first channel, and the first channel corresponds to a first read bus group and a first read/write bus group. The method may include the following steps.

S301: The processor accesses the first channel in the memory through the first read bus group and the first read/write bus group.

The memory includes a first channel and a second channel. The first channel may be any channel in the at least one channel. It should be noted that for related descriptions of the memory, refer to the descriptions in FIG. 3. Details are not described herein again in this embodiment of this application.

The first read bus group may include a control bus, an address bus, and a data bus. For example, in the first read bus group, the control bus may include a clock line CLK and a chip enable line CEN, the address bus may include m1 address lines A[m1-1:0], and the data bus may include n1 read data lines Q[n1-1:0]. m1 and n1 are positive integers. For example, m1 is equal to 32, and n1 is equal to 128.

The first read/write bus group may also include a control bus, an address bus, and a data bus. For example, in the first read/write bus group, the control bus may include a clock line CLK, a chip enable line CEN, and a write enable line WEN, the address bus may include m2 address lines A[m2-1:0], and the data bus may include n2 read data lines Q[n2-1:0] and n3 write data lines D[n3-1:0].

Specifically, the processor enables the first read/write bus group as a write bus group, for example, sets the write enable line WEN to a low level, so that the first read/write bus group is used as a write bus group; reads data of the first channel in the memory through the first read bus group, for example, enables the chip enable line CEN, and reads data of the first channel through the address line A[m1-1:0] and the read data line Q[n1-1:0] at a rising/falling edge of a clock signal corresponding to the clock line CLK; writes data into the first channel in the memory through the first read/write bus group, for example, enables the chip enable line CEN, and writes data into the first channel through the address line A[m2-1:0] and the write data line D[n3-1:0] at a rising/falling edge of the clock signal corresponding to the clock line CLK.

Alternatively, the processor enables the first read/write bus group as a read bus group, for example, sets the write enable line WEN to a high level, so that the first read/write bus group is used as a read bus group; reads data of the first channel in the memory through the first read bus group and the first read/write bus group, for example, enables the chip enable line CEN, and reads data of the first channel through the address line A[m1-1:0] and the read data line Q[n3-1:0], and the address line A[m2-1:0] and the read data line Q[n2-1:0] at a rising/falling edge of a clock signal corresponding to the clock line CLK.

In this embodiment of this application, the first channel in the memory corresponds to the first read bus group and the first read/write bus group. When the first channel in the memory is accessed, the first read/write bus group may be adaptively used as a read bus group or a write bus group based on a read/write bandwidth requirement during data read/write, so that the first read bus group and the first read/write bus group access the first channel in the memory. This meets requirements of a same memory for different read/write bandwidths.

For example, when the first channel in the memory is configured to store a service packet, the processor may enable the first read/write bus group as a write bus group, read the service packet of the first channel in the memory through the first read bus group, and write the service packet into the first channel in the memory through the first read/write bus group. When the first channel in the memory is configured to store a service entry, the processor may enable the first read/write bus group as a read bus group, and read the service entry of the first channel in the memory through the first read bus group and the first read/write bus group.

According to the invention, the memory further includes a second channel. The second channel corresponds to a second read/write bus group. The method further includes S302: The processor accesses the second channel in the memory through the second read/write bus group.

A specific process in which the processor accesses the second channel in the memory through the second read/write bus group is similar to a specific process in which the processor accesses the first channel in the memory through the first read/write bus group in S301. For details, refer to related descriptions in S301. Details are not described herein again in this embodiment of this application.

In an actual application, the second channel may correspond to one group of buses, or may correspond to two groups of buses. For example, when the second channel corresponds to one group of buses, the second channel corresponds to only the second read/write bus group. That is, the second channel can be accessed only through the second read/write bus group. When the second channel corresponds to two groups of buses, in addition to corresponding to the second read/write bus group, the second channel may also correspond to a second read bus, that is, similar to the first channel, the second channel may correspond to a group of read buses and a group of read/write buses.

The second channel further corresponds to a second read bus group. The method further includes S303: The processor reads data of the second channel through the second read bus group.

A specific process in which the processor accesses the second channel in the memory through the second read bus group is similar to a specific process in which the processor accesses the first channel in the memory through the first read bus group in S301. For details, refer to related descriptions in S301. Details are not described herein again in this embodiment of this application.

It should be noted that there may be no sequence between S301, S302, and S303, or there may be no sequence between S302 and S303. In FIG. 5, an example in which S302 and S303 are performed after S301, and S302 and S303 are performed in parallel is used for description.

In an actual application, the memory in the network device may include a plurality of channels. For example, the memory may be a memory including N SRAMs in a three-dimensional stacking manner. If each SRAM includes two channels, the memory may include 2N channels. Similar to the first channel or the second channel, one or more channels in the plurality of channels may be correspondingly provided with a read bus group and a read/write bus group, so that when a channel is accessed, the channel may be accessed through the read bus group and the read/write bus group corresponding to the channel.

It should be noted that, for related descriptions of the first read bus group, the first read/write bus group, the second read bus group, and the second read/write bus group in S301 to S303, refer to the related descriptions in FIG. 3. Details are not described herein again in this embodiment of this application.

In the data access method provided in this embodiment of this application, a first channel in the memory corresponds to a read bus group and a read/write bus group. When accessing the memory, the processor may adaptively use, based on a read/write bandwidth requirement during data read/write, a read/write bus group corresponding to the first channel as a read bus group or a write bus group, so as to access the memory based on the read bus group and the read/write bus group. This meets requirements of a same network device for different read/write bandwidths.

In conclusion, the foregoing descriptions are merely specific implementations of this application, but are not intended to limit the protection scope of this application. Any variation or replacement within the technical scope disclosed in this application shall fall within the protection scope of the claims.

## Claims

1. A memory (201), wherein the memory (201) comprises:
at least one channel, wherein the at least one channel comprises a first channel; and
the first channel corresponds to a first read bus group of the memory and a first read/write bus group of the memory,
the first read bus group is configured to read data of the first channel, and the first read/write bus group is configured to read data of the first channel and to write data into the first channel;
wherein the at least one channel further comprises a second channel, the second channel corresponds to a second read/write bus group of the memory, and the second read/write bus group is configured to read data of the second channel and to write data into the second channel;
**characterised in that**
the first read and write bus group supports bit mask reading and writing, and the second read and write bus group supports byte mask reading and writing but not bit mask reading and writing.

2. The memory (201) according to claim 1, wherein bus bit widths of the first read/write bus group and the second read/write bus group are different.

3. The memory (201) according to any one of claims 1 to 2, wherein the second channel further corresponds to a second read bus group, and the second read bus group is configured to read data of the second channel.

4. The memory (201) according to claim 3, wherein bus bit widths of the first read bus group and the second read bus group are different.

5. The memory (201) according to claim 3 or 4, wherein at least one read bus in the first read bus group has a different read function from that in the second read bus group.

6. A network device, wherein the network device comprises a processor (202) and a memory (201), the processor (202) is configured to access the memory (201), and the memory (201) is the memory (201) according to any one of claims 1 to 5.

7. The network device according to claim 6, wherein the network switching and forwarding device comprises a router or a switch.

8. A data access method, applied to a network device comprising a processor (202) and a memory (201), wherein the memory (201) comprises a first channel, the first channel corresponds to a first read bus group and a first read/write bus group, the first read bus group being configured to read data of the first channel, and the first read/write bus group being configured to read data of the first channel and to write data into the first channel, and the method comprises:
(S301) accessing, by the processor(202), the first channel in the memory (201) through the first read bus group and the first read/write bus group;
wherein the memory (201) further comprises a second channel, the second channel corresponds to a second read/write bus group, the second read/write bus group being configured to read data of the second channel and the second read/write bus group being configured to write data into the second channel, and the method further comprises:
(S302) accessing, by the processor (202), the second channel in the memory (201) through the second read/write bus group;
**characterised in that** the first read and write bus group supports bit mask reading and writing, and the second read and write bus group supports byte mask reading and writing but not bit mask reading and writing.

9. The method according to claim 8, wherein the accessing, by the processor (202), the first channel in the memory (201) through the first read bus group and the first read/write bus group comprises:
enabling, by the processor (202), the first read/write bus group as a write bus group; and
reading, by the processor (202), data of the first channel in the memory (201) through the first read bus group, and writing data into the first channel in the memory (201) through the first read/write bus group.

10. The method according to claim 8 or 9, wherein the accessing, by the processor (202), the first channel in the memory (201) through the first read bus group and the first read/write bus group further comprises:
enabling, by the processor (202), the first read/write bus group as a read bus group; and
reading, by the processor (202), data of the first channel in the memory (201) through the first read bus group and the first read/write bus group.

11. The method according to claim 8, wherein the second channel further corresponds to a second read bus group, and the method further comprises:
(S303) reading, by the processor (202), data of the second channel through the second read bus group.

## Patentansprüche

1. Speicher (201), wobei der Speicher (201) Folgendes umfasst:
mindestens einen Kanal, wobei der mindestens eine Kanal einen ersten Kanal umfasst; und
der erste Kanal einer ersten Lesebusgruppe des Speichers und einer ersten Lese-/Schreibbusgruppe des Speichers entspricht,
die erste Lesebusgruppe dazu konfiguriert ist, Daten des ersten Kanals zu lesen, und die erste Lese-/Schreibbusgruppe dazu konfiguriert ist, Daten des ersten Kanals zu lesen und Daten in den ersten Kanal zu schreiben;
wobei der mindestens eine Kanal ferner einen zweiten Kanal umfasst, der zweite Kanal einer zweiten Lese-/Schreibbusgruppe des Speichers entspricht und die zweite Lese-/Schreibbusgruppe dazu konfiguriert ist, Daten des zweiten Kanals zu lesen und Daten in den zweiten Kanal zu schreiben;
**dadurch gekennzeichnet, dass** die erste Lese- und Schreibbusgruppe das Lesen und Schreiben von Bitmasken unterstützt, und
die zweite Lese- und Schreibbusgruppe das Lesen und Schreiben von Bytemasken, jedoch nicht das Lesen und Schreiben von Bitmasken unterstützt.

2. Speicher (201) gemäß Anspruch 1, wobei die Busbitbreiten der ersten Lese-/Schreibbusgruppe und der zweiten Lese-/Schreibbusgruppe unterschiedlich sind.

3. Speicher (201) gemäß einem der Ansprüche 1 oder 2, wobei der zweite Kanal ferner einer zweiten Lesebusgruppe entspricht und die zweite Lesebusgruppe dazu konfiguriert ist, Daten des zweiten Kanals zu lesen.

4. Speicher (201) gemäß Anspruch 3, wobei die Busbitbreiten der ersten Lesebusgruppe und der zweiten Lesebusgruppe unterschiedlich sind.

5. Speicher (201) gemäß Anspruch 3 oder 4, wobei mindestens ein Lesebus in der ersten Lesebusgruppe eine andere Lesefunktion aufweist als der Lesebus in der zweiten Lesebusgruppe.

6. Netzwerkvorrichtung, wobei die Netzwerkvorrichtung einen Prozessor (202) und einen Speicher (201) umfasst, der Prozessor (202) dazu konfiguriert ist, auf den Speicher (201) zuzugreifen, und der Speicher (201) der Speicher (201) gemäß einem der Ansprüche 1 bis 5 ist.

7. Netzwerkvorrichtung gemäß Anspruch 6, wobei die Netzwerkumschalt- und Weiterleitungsvorrichtung einen Router oder einen Schalter umfasst.

8. Datenzugriffsverfahren, angewendet auf eine Netzwerkvorrichtung mit einem Prozessor (202) und einem Speicher (201), wobei der Speicher (201) einen ersten Kanal umfasst, der einer ersten Lesebusgruppe und einer ersten Lese-/Schreibbusgruppe entspricht, wobei die erste Lesebusgruppe dazu konfiguriert ist, Daten des ersten Kanals zu lesen, und die erste Lese-/Schreibbusgruppe dazu konfiguriert ist, Daten des ersten Kanals zu lesen und Daten in den ersten Kanal zu schreiben, und das Verfahren Folgendes umfasst:
(S301) Zugriff auf den ersten Kanal im Speicher (201) über die erste Lesebusgruppe und die erste Lese-/Schreibbusgruppe durch den Prozessor (202);
wobei der Speicher (201) ferner einen zweiten Kanal umfasst, der einer zweiten Lese-/Schreibbusgruppe entspricht, wobei die zweite Lese-/Schreibbusgruppe dazu konfiguriert ist, Daten des zweiten Kanals zu lesen und die zweite Lese-/Schreibbusgruppe dazu konfiguriert ist, Daten in den zweiten Kanal zu schreiben, und das Verfahren ferner Folgendes umfasst:
(S302) Zugriff auf den zweiten Kanal im Speicher (201) über die zweite Lese-/Schreibbusgruppe durch den Prozessor (202);
**dadurch gekennzeichnet, dass** die erste Lese- und Schreibbusgruppe das Lesen und Schreiben von Bitmasken, die zweite Lese- und Schreibbusgruppe jedoch das Lesen und Schreiben von Bytemasken, nicht aber das Lesen und Schreiben von Bitmasken unterstützt.

9. Verfahren gemäß Anspruch 8, wobei der Zugriff durch den Prozessors (202) auf den ersten Kanal im Speicher (201) über die erste Lesebusgruppe und die erste Lese-/Schreibbusgruppe Folgendes umfasst:
Aktivieren der ersten Lese-/Schreibbusgruppe als Schreibbusgruppe durch den Prozessor (202); und
Lesen der Daten des ersten Kanals im Speicher (201) über die erste Lesebusgruppe und schrieben der Daten in den ersten Kanal im Speicher (201) über die erste Lese-/Schreibbusgruppe durch den Prozessor (202).

10. Verfahren gemäß Anspruch 8 oder 9, wobei der Zugriff durch den Prozessors (202) auf den ersten Kanal im Speicher (201) über die erste Lesebusgruppe und die erste Lese-/Schreibbusgruppe ferner Folgendes umfasst:
Aktivieren der ersten Lese-/Schreibbusgruppe als Lesebusgruppe durch den Prozessor (202); und
Lesen der Daten des ersten Kanals im Speicher (201) über die erste Lesebusgruppe die erste Lese-/Schreibbusgruppe durch den Prozessor (202).

11. Verfahren gemäß Anspruch 8, wobei der zweite Kanal ferner einer zweiten Lesebusgruppe entspricht, und das Verfahren ferner Folgendes umfasst:
(S303) Lesen der Daten des zweiten Kanals durch den Prozessor (202) über die zweite Lesebusgruppe.

## Revendications

1. Mémoire (201), dans laquelle la mémoire (201) comprend :
au moins un canal, dans lequel l'au moins un canal comprend un premier canal ; et
le premier canal correspond à un premier groupe de bus de lecture de la mémoire et à un premier groupe de bus de lecture/écriture de la mémoire, le premier groupe de bus de lecture est configuré pour lire les données du premier canal, et le premier groupe de bus de lecture/écriture est configuré pour lire les données du premier canal et pour écrire des données dans le premier canal ;
dans lequel l'au moins un canal comprend également un second canal, le second canal correspond à un second groupe de bus de lecture/écriture de la mémoire, et le second groupe de bus de lecture/écriture est configuré pour lire les données du second canal et pour écrire des données dans le second canal ;
**caractérisé en ce que** le premier groupe de bus de lecture et d'écriture prend en charge la lecture et l'écriture de masques de bits, et
le second groupe de bus de lecture et d'écriture prend en charge la lecture et l'écriture de masques d'octets mais pas la lecture et l'écriture de masques de bits.

2. Mémoire (201) selon la revendication 1, dans laquelle les largeurs de bits de bus du premier groupe de bus de lecture/écriture et du second groupe de bus de lecture/écriture sont différentes.

3. Mémoire (201) selon l'une quelconque des revendications 1 et 2, dans laquelle le second canal correspond également à un second groupe de bus de lecture, et le second groupe de bus de lecture est configuré pour lire les données du second canal.

4. Mémoire (201) selon la revendication 3, dans laquelle les largeurs de bits de bus du premier groupe de bus de lecture/écriture et du second groupe de bus de lecture/écriture sont différentes.

5. Mémoire (201) selon la revendication 3 ou 4, dans laquelle au moins un bus de lecture du premier groupe de bus de lecture a une fonction de lecture différente de celle du second groupe de bus de lecture.

6. Dispositif réseau, dans lequel le dispositif réseau comprend un processeur (202) et une mémoire (201), le processeur (202) est configuré pour accéder à la mémoire (201), et la mémoire (201) est la mémoire (201) selon l'une quelconque des revendications 1 à 5.

7. Dispositif réseau selon la revendication 6, dans lequel le dispositif de commutation et de transfert de réseau comprend un routeur ou un commutateur.

8. Procédé d'accès aux données, appliqué à un dispositif réseau comprenant un processeur (202) et une mémoire (201), dans lequel la mémoire (201) comprend un premier canal, le premier canal correspondant à un premier groupe de bus de lecture et à un premier groupe de bus de lecture/écriture, le premier groupe de bus de lecture étant configuré pour lire les données du premier canal, et le premier groupe de bus de lecture/écriture étant configuré pour lire les données du premier canal et pour écrire des données dans le premier canal, et le procédé comprend :
(S301) l'accès, par le processeur (202), au premier canal dans la mémoire (201) via le premier groupe de bus de lecture et le premier groupe de bus de lecture/écriture ;
dans lequel la mémoire (201) comprend également un second canal, le second canal correspond à un second groupe de bus de lecture/écriture, le second groupe de bus de lecture/écriture étant configuré pour lire les données du second canal et le second groupe de bus de lecture/écriture étant configuré pour écrire des données dans le second canal, et le procédé comprend également :
(S302) l'accès, par le processeur (202), au second canal dans la mémoire (201) via le second groupe de bus de lecture/écriture ;
**caractérisé en ce que** le premier groupe de bus de lecture et d'écriture prend en charge la lecture et l'écriture de masques de bits, et le second groupe de bus de lecture et d'écriture prend en charge la lecture et l'écriture de masques d'octets mais pas la lecture et l'écriture de masques de bits.

9. Procédé selon la revendication 8, dans lequel l'accès, par le processeur (202), au premier canal dans la mémoire (201) via le premier groupe de bus de lecture et le premier groupe de bus de lecture/écriture comprend :
l'activation, par le processeur (202), du premier groupe de bus de lecture/écriture en tant que groupe de bus d'écriture ; et
la lecture, par le processeur (202), des données du premier canal dans la mémoire (201) via le premier groupe de bus de lecture, et l'écriture de données dans le premier canal dans la mémoire (201) via le premier groupe de bus de lecture/écriture.

10. Procédé selon la revendication 8 ou 9, dans lequel l'accès, par le processeur (202), au premier canal dans la mémoire (201) via le premier groupe de bus de lecture et le premier groupe de bus de lecture/écriture comprend également :
l'activation, par le processeur (202), du premier groupe de bus de lecture/écriture en tant que groupe de bus de lecture ; et
la lecture, par le processeur (202), de données du premier canal dans la mémoire (201) via le premier groupe de bus de lecture et le premier groupe de bus de lecture/écriture.

11. Procédé selon la revendication 8, dans lequel le second canal correspond également à un second groupe de bus de lecture, et le procédé comprend également :
(S303) la lecture, par le processeur (202), des données du second canal via le second groupe de bus de lecture.
